Europäisches Patentamt

European Patent Office

Office européen des brevets

(11) Numéro de publication: **0 240 378**
**A1**

# (12) DEMANDE DE BREVET EUROPEEN

(21) Numéro de dépôt: **87400361.9**

(22) Date de dépôt: **19.02.87**

(51) Int. Cl.⁴: **G 02 F 1/133**

(30) Priorité: **28.02.86 FR 8602854**

(43) Date de publication de la demande:
**07.10.87 Bulletin 87/41**

(84) Etats contractants désignés:
**CH DE GB IT LI NL**

(71) Demandeur: **COMMISSARIAT A L'ENERGIE ATOMIQUE Etablissement de Caractère Scientifique Technique et Industriel**
**31/33, rue de la Fédération**
**F-75015 Paris (FR)**

(72) Inventeur: **Montmayeul, Brigitte**
**7, rue les Lagrange**
**F-38100 Grenoble (FR)**

**Renard, Stéphane**
**Le Chateau, Champ Sur Drac Village**
**F-38560 Jarrie (FR)**

(74) Mandataire: **Mongrédien, André et al**
**c/o BREVATOME 25, rue de Ponthieu**
**F-75008 Paris (FR)**

(54) Filtres colorès, leur procédé de fabrication et solution utilisable pour la mise en oeuvre de ce procédé.

(57) Filtres colorés, leur procédé de fabrication et solution utilisable pour la mise en oeuvre de ce procédé.

Ces filtres colorés sont constitués par un polyamide durci contenant un colorant plastosoluble.

Ils peuvent être formés par un procédé lithographique en effectuant le cycle de traitement suivant :

a) dépôt sur un substrat (1) d'une première couche (3) d'une solution d'au moins un polymère et d'au moins un colorant plastosoluble,

b) dépôt d'une deuxième couche (5) de résine photosensible,

c) irradiation de certaines zones de la deuxième couche (5) de résine photosensible de façon à définir les emplacements des filtres,

d) élimination de la résine photosensible (5),

e) élimination de la couche de polymère et de colorant (3) sur les zones du substrat qui ne sont plus protégées, et

f) recuit du substrat revêtu pour durcir les filtres colorés.

Pour obtenir une mosaïque de filtres colorés, on répète ce cycle de traitement plusieurs fois en utilisant dans l'étape a) un colorant plastosoluble différent et en définissant dans les étapes c) à e) des emplacements de filtres différents.

FIG. 1

EP 0 240 378 A1

**Description**

FILTRES COLORES, LEUR PROCEDE DE FABRICATION ET SOLUTION UTILISABLE POUR LA MISE EN OEUVRE DE CE PROCEDE

La présente invention a pour objet un procédé de réalisation de filtres colorés, utilisable en particulier pour former des mosaïques de filtres colorés sur les écrans de cellules à cristaux liquides afin de teinter localement la lumière modulée par la cellule.

Ces mosaïques de filtres colorés peuvent être utilisées dans les écrans plats de télévision en couleur ou dans les écrans de terminal d'ordinateur en couleur.

On sait que pour obtenir de tels écrans, il est nécessaire de réaliser des triades de filtres colorés en rouge, en vert, et en bleu qui soient susceptibles de se fusionner lors d'une observation à une certaine distance afin d'obtenir les images par colorimétrie additive.

Les écrans à cristaux liquides en couleur peuvent être de deux types :

- les écrans multiplexés à adressage direct par l'intersection d'une ligne et d'une colonne,

- les écrans à matrice active où l'information est stockée à l'aide d'une matrice de transistors déposés en couche mince sur une des faces de la cellule.

Pour un bon fonctionnement de ces écrans, il est nécessaire que les filtres soient situés le plus près possible du plan de génération de l'image pour éviter des variations désagréables de couleur en vision sous incidence. Ceci peut être obtenu en disposant les filtres soit directement sur les électrodes de la cellule, soit sur une lame de verre disposée à l'extérieur de la cellule au-dessus des électrodes. On peut aussi former les filtres colorés lors de la fabrication de la cellule en les disposant sur une lame de verre et en déposant ensuite au-dessus des filtres colorés les électrodes de la cellule.

Les procédés connus actuellement pour la réalisation de telles mosaïques de filtres colorés font appel à différentes techniques.

Ainsi le brevet américain 4.522.691 accordé à Seiko Instruments Electronics Ltd décrit un procédé de réalisation d'une mosaïque de filtres colorés qui consiste à déposer directement sur les électrodes de la cellule des films minces de polymère coloré par électrodéposition en utilisant les électrodes de la cellule comme électrodes de dépôt.

Le brevet européen EP-A-0.135.373 décrit un procédé pour former une mosaïque de filtres colorés à l'extérieur d'une cellule à cristaux liquides, qui consiste à déposer sur la surface externe de la paroi transparente supportant les électrodes trois couches d'émulsions photosensibles dont chacune est sensible à une lumière de couleur différente, puis à illuminer ces couches par une lumière appropriée en utilisant les électrodes de la cellule et le cristal liquide qu'elle contient pour définir les emplacements des filtres colorés.

Les techniques décrites ci-dessus de réalisation de mosaïques de filtres colorés sont difficiles à inclure dans les processus classiques de fabrication de cellules à cristaux liquides qui font généralement appel aux techniques de photolithographie. De plus, les procédés décrits ci-dessus ne permettent pas de disposer les filtres indifféremment à l'intérieur ou à l'extérieur de la cellule à cristaux liquides.

On connaît toutefois quelques réalisations de filtres colorés faisant appel à des techniques photolithographiques.

Ainsi, dans le brevet américain 4.383.017 accordé à Dainippon Screen Mfg, Ltd on forme les filtres colorés en déposant sur un substrat une composition liquide colorée sensible aux rayonnements ultraviolets et l'on soumet certaines zones de la couche à une irradiation au moyen de rayons ultraviolets pour former sur ces zones les filtres colorés. On peut recommencer cette opération ensuite avec des compositions liquides de couleurs différentes pour obtenir une mosaïque de filtres colorés en rouge, en bleu, et en vert.

Cette technique qui est proche de la photolithogr        hie, implique ainsi l'utilisation de polymères sensibles aux rayonnements ultraviolets. Ceci constitue un inconvénient car les filtres colorés durcis restent sensibles aux rayonnements et ne présentent pas de ce fait une bonne résistance à la lumière, ce qui ne permet pas d'obtenir la résistance au veillissement souhaité.

L'article : "A Full Color Matrix LCD With Color Layers On The Electrodes" de Tatsuo Uchida et al. paru dans 1982 International Display Research Conference p. 166-170, décrit un procédé photolithographique pour former des filtres colorés sur les électrodes transparentes d'une cellule à cristaux liquides. Selon ce procédé, on dépose tout d'abord une couche de gélatine sur l'ensemble des électrodes, on durcit ensuite la couche de gélatine aux endroits qui correspondent aux électrodes par irradiation au moyen de rayonnements ultraviolets en utilisant un masque approprié et en éliminant ensuite la gélatine non durcie, puis on dépose sur les électrodes ainsi revêtues une couche de résine photosensible que l'on soumet ensuite à une irradiation à travers un masque pour protéger uniquement les électrodes ne devant pas être colorées, et on colore enfin la couche de gélatine présente sur les électrodes non protégées. On recommence ensuite ces opérations pour obtenir successivement des électrodes recouvertes de rouge, de bleu et de vert.

Ce procédé présente lui aussi l'inconvénient de nécessiter l'emploi d'un produit sensible aux rayonnements ultraviolets pour la formation des filtres colorés. Par ailleurs, ce procédé ne permet pas d'inclure de façon homogène le colorant dans la couche déposée sur les électrodes, puisque l'opération de coloration des filtres est effectuée après durcissement de la couche de gélatine. Enfin, on peut noter que ce procédé nécessite l'utilisation successive de quatre masques pour obtenir la mosaïque de filtres colorés en rouge, en bleu et en vert.

La présente invention a précisément pour objet des filtres colorés et un procédé de réalisation de tels filtres qui pallie les inconvénients précités.

Le filtre coloré selon l'invention se caractérise en ce qu'il est constitué par un polymère durci par traitement thermique contenant un colorant plastosoluble.

Ce polymère qui peut, par exemple, être un polyamide permet d'obtenir les caractéristiques voulues de résistance au vieillissement et de résistance à la température, ce qui est intéressant pour la fabrication des cellules à cristaux liquides car celle-ci peut nécessiter l'emploi de températures allant jusqu'à 170°C.

De plus, grâce aux propriétés du polymère, ces filtres colorés peuvent être réalisés par un procédé photolithographique.

Aussi, la présente invention a également pour objet un procédé de réalisation de filtres colorés sur un substrat.

Ce procédé comprend une étape de définition des emplacements des filtres par un procédé lithographique utilisant une couche de résine photosensible et un premier solvant pour éliminer la résine photosensible aux endroits voulus et il se caractérise en ce qu'il consiste à réaliser au moins un cycle de traitement comprenant les étapes successives suivantes :

a) dépôt sur le substrat d'une première couche d'une solution d'au moins un polymère insoluble dans le premier solvant et d'au moins un colorant plastosoluble,

b) dépôt d'une deuxième couche de résine photosensible,

c) irradiation de certaines zones de la deuxième couche de résine photosensible de façon à définir les emplacements des filtres,

d) élimination de la résine photosensible par le premier solvant sur les zones du substrat ne correspondant pas auxdits emplacements,

e) élimination de la couche de polymère et de colorant par un second solvant sur les zones du substrat qui ne sont plus protégées par la résine photosensible, ledit second solvant ne dissolvant pas la résine photosensible qui reste sur le substrat après l'étape d), et

f) recuit du substrat revêtu à une température et pendant une durée suffisantes pour durcir les filtres colorés.

Le polymère utilisé pour la réalisation des filtres colorés de l'invention présente une bonne solubilité dans les solvants acides organiques mais reste insoluble dans les solvants, les révélateurs et les résines généralement utilisés dans les techniques photolithographiques. De préférence, le polymère choisi est également stable aux températures mises en oeuvre lors de la réalisation de cellules à cristaux liquides, températures qui peuvent aller jusqu'à 170°C.

Pour être utilisé dans l'invention, le polymère doit de plus être soluble dans un solvant capable de dissoudre les quantités voulues de colorant en formant une solution susceptible d'être utilisée pour de dépôt d'une couche mince, ayant par exemple une épaisseur de 0,5 à 20 μm.

Comme on l'a vu précédemment, les polyamides sont des polymères répondant à ces caractéristiques. En effet, ils peuvent être dissous dans un solvant acide organique avec des colorants ayant une bonne stabilité à la lumière en donnant des solutions convenant à la réalisation de l'étape a), soit la formation d'une couche mince. Ils présentent, par ailleurs, des propriétés de tenue en température et de résistance aux bases et à de nombreux solvants organiques.

A titre d'exemple de polyamides susceptibles d'être utilisés dans l'invention, on peut citer le PA6 commercialisé par Rhône Poulenc

Avec de tels polymères, on peut utiliser comme solvants, des acides organiques tels que l'acide formique qui peut dissoudre simultanément de nombreux colorants.

Ainsi, une solution convenant à la réalisation de l'étape a) peut être constituée par une solution d'au moins un polyamide et d'au moins un colorant plastosoluble dans de l'acide formique.

Le procédé de l'invention permet ainsi de former des filtres colorés à partir d'un polymère qui n'est pas sensible aux rayonnements ultraviolets. Par ailleurs, le fait d'utiliser des polymères colorés durcissables thermiquement permet de réaliser successivement sur le même substrat des filtres colorés juxtaposés de couleurs différentes.

Aussi l'invention a également pour objet un procédé de réalisation d'une mosaïque de filtres colorés, qui consiste à effectuer le premier cycle de traitement décrit ci-dessus et à répéter ensuite au moins une fois ce cycle de traitement en utilisant dans l'étape a) un colorant plastosoluble différent et en définissant dans les étapes c) à e) des emplacements de filtres différents.

Le procédé de l'invention peut être mis en oeuvre aussi bien avec des résines photosensibles positives qu'avec des résines photosensibles négatives. On rappelle que les résines photosensibles négatives sont des résines qui deviennent moins solubles lorsqu'on les a exposées à une irradiation, alors que les résines positives sont des résines qui deviennent plus solubles après irradiation.

De préférence, lorsqu'on utilise une résine photosensible négative, on peut choisir une résine qui soit transparente après irradiation.

Les différentes étapes du procédé de l'invention peuvent être effectuées en faisant appel à des techniques classiques, faciles à mettre en oeuvre.

Ainsi, le dépôt de la première couche de solution de polymère et de colorant dans le solvant peut être effectuée par des techniques simples, par exemple par dépôt à la tournette, par trempage, ou par vaporisation. La quantité de solvant utilisée dans la solution est la plus faible possible, c'est-à-dire une quantité suffisante pour dissoudre les proportions voulues de polymère et de colorant et nécessaire pour obtenir la viscosité désirée.

La quantité de colorant dans la solution est généralement supérieure à la quantité de polymère ; on utilise par exemple 30-40% en poids de polymère et 60 à 70% en poids de colorant. Les colorants sont choisis en fonction de leur solubilité dans les solvants organiques capables de dissoudre le polymère et de leur résistance à la lumière. On peut utiliser des colorants classiques, par exemple les colorants vendus par Ciba Geigy sous la marque Rouge Filamid 11368 et les colorants vendus par Imperial Chemical Industry sous les dénominations Vert Endanil B et Bleu Endanil B.

Après le dépôt de la première couche du polymère non soluble et du colorant plastosoluble, on dépose la couche de résine photosensible par les procédés habituellement utilisés pour ce type de résine. On soumet ensuite certaines zones de la deuxième couche de résine photosensible à une irradiation de façon à définir les emplacements des filtres. Ceci peut être effectué en utilisant un masque de forme appropriée à la polarité de la résine. Ainsi, dans le cas où l'on utilise une résine négative, le masque doit laisser passer la lumière aux emplacements où la résine doit être conservée. En revanche, dans le cas où l'on utilise une résine positive, le masque doit laisser passer la lumière sur les emplacements où la résine doit être enlevée.

Généralement, l'irradiation est effectuée au moyen de rayonnements ultraviolets. On peut toutefois utiliser d'autres rayonnements, par exemple des faisceaux d'électrons.

Après cette opération, on élimine la résine photosensible aux endroits voulus par dissolution dans des solvants adaptés à la résine utilisée. Généralement, on rince ensuite le substrat et on le sèche. Dans le cas où l'on utilise une résine négative, on dissout la résine qui n'a pas été soumise à l'irradiation. En revanche, dans le cas où l'on utilise une résine positive, on dissout la résine qui a subi l'irradiation.

Après cette étape, on élimine la couche de polymère et de colorant qui n'est plus protégée par la résine en utilisant un solvant approprié qui ne soit pas capable de dissoudre la couche de résine qui protège certaines zones du substrat. Ce second solvant peut être constitué par au moins un alcool ou un polyalcool, par exemple du méthanol, de l'éthanol, du diéthylène glycol ou leurs mélanges. On peut aussi utiliser une solution aqueuse d'acide formique. Après cette élimination, on rince de préférence le substrat revêtu dans un alcool tel que l'isopropanol, puis on le sèche, et on le soumet ensuite au traitement de recuit. La durée et la température du traitement de recuit sont choisies en fonction de la nature de polymère et du colorant utilisés. Le traitement de recuit peut avoir une durée allant de 3 minutes à 2h et il est généralement effectué à des températures de 100 à 170°C.

Lorsqu'on utilise une résine photosensible négative, qui est transparente après irradiation, on peut conserver cette couche de résine sur les filtres colorés, car elle constitue dans ce cas une bonne couche de protection.

En revanche, lorsqu'on utilise une résine photosensible positive, il est préférable d'éliminer cette résine à la fin du dernier cycle de traitement avant d'effectuer le traitement de recuit correspondant à ce dernier cycle. Cette élimination peut être réalisée par dissolution dans un solvant approprié tel que l'isobutylméthyl cétone.

Les filtres colorés obtenus selon l'invention peuvent être sous la forme d'une mosaïque de filtres colorés de couleurs différentes, chaque filtre coloré étant constitué par un polyamide durci contenant un colorant plastosoluble de couleur différente de celle des filtres colorés adjacents.

Lorsque le procédé de l'invention est utilisé pour la réalisation des écrans couleurs de cellules à cristaux liquides, il permet de disposer la mosaïque de filtres colorés, soit à l'intérieur de la cellule sur les électrodes conductrices transparentes, soit à l'extérieur de la cellule sur une lame de verre mince, soit encore sur une lame de verre constituant l'une des parois de la cellule, afin que l'on puisse former au-dessus des filtres colorés des électrodes conductrices transpatentes.

Ainsi, le procédé de l'invention est particulièrement intéressant car il peut être mis en oeuvre quel que soit le type d'écran à réaliser. De plus, il peut s'insérer de manière aisée dans un procédé photolithographique classique, ce qui est intéressant lorsqu'on veut industrialiser la fabrication des mosaïques de filtres colorés.

D'autres caractéristiques et avantages de l'invention apparaîtront mieux à la lecture des exemples suivants donnés bien entendu à titre illustratif et non limitatif en référence au dessin annexé sur lequel :

- les figures 1a à 1e représentent un premier cycle de traitement conforme au procédé de l'invention,

- les figures 2a à 2e représentent un deuxième cycle de traitement conforme au procédé de l'invention, et

- les figures 3a à 3e représentent un troisième cycle de traitement conforme au procédé de l'invention.

Exemple 1

Dans cet exemple, on décrit la réalisation d'une mosaïque de filtres colorés en rouge, en vert et en bleu, mettant en oeuvre trois cycles de traitement selon l'invention, et utilisant comme résine photosensible une résine négative commercialisée par Kodak sous la référence Negative Photoresist 747 Standard Kodak.

On prépare tout d'abord les différentes solutions colorées qui seront utilisées pour la réalisation de l'étape a) de chaque cycle. Dans ce but, on dissout 2,6g de polyamide dans 100ml d'acide formique en utilisant comme polyamide le produit vendu sous la marque PA6. A partir du mélange obtenu, on forme une première solution colorée en rouge en utilisant 25ml du mélange de base auquel on ajoute 1,1g de Rouge Filamid 11368 de Ciba-Geigy.

On prépare ensuite une deuxième solution colorée en vert en ajoutant à 25ml du mélange de base 1g de Vert Endanil B de Imperial Chemical Industries, puis une troisième solution colorée en Bleu en ajoutant à 25ml du mélange de base, 1,5g de Bleu Endanil B de Imperial Chemical Industries.

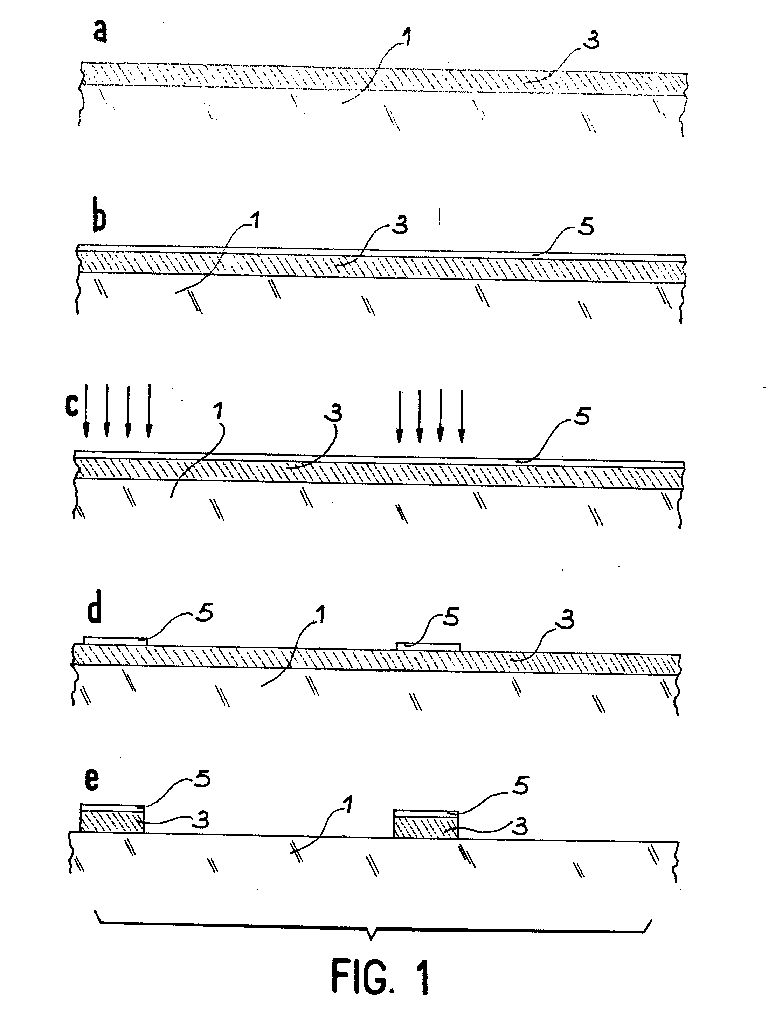

On réalise alors un premier cycle de traitement pour former les filtres colorés en rouge. Ce premier cycle de traitement est illustré sur les figures 1a à 1e.

Dans ce but, on dépose sur un substrat 1 constitué par une lame mince de verre transparente une couche 3 de la première solution colorée en rouge (figure 1a). Après séchage de la couche 3, on dépose sur le substrat une couche 5 de la résine photosensible négative mentionnée ci-dessus (figure 1b). On soumet ensuite le substrat revêtu des deux couches à une insolation au travers d'un masque correspondant au tracé à obtenir en réalisant l'insolation pendant 10s (figure 1c). On développe ensuite la résine pour éliminer les zones non soumises à l'insolation en immergeant le substrat revêtu pendant 1 min dans le développeur Kodak correspondant. On rince ensuite l'emsemble pendant 20 à 30s dans le bain de rinçage Kodak correspondant.

Après ces opérations, on obtient la structure représentée sur la figure 1d sur laquelle les zones de la couche 3 qui devront former les filtres colorés sont protégées par la couche 5 de résine photosensible irradiée. On élimine alors la couche 3 aux endroits où elle n'est pas protégée par la résine 5. Ceci est effectué en décolorant tout d'abord la couche non protégée avec de l'éthanol puis en chassant le polymère décoloré qui reste par frottage.

On obtient ainsi la structure représentée sur la figure 1e où les filtres colorés formés à partir de la couche 3 sont disposés sur le substrat 1 aux endroits voulus et revêtus d'une couche de résine photosensible 5 irradiée.

On rince alors le substrat revêtu à l'isopropanol, puis on le sèche pendant 1/4h à 120°C et on le soumet à un traitement de recuit effectué à 160°C pendant 6 min.

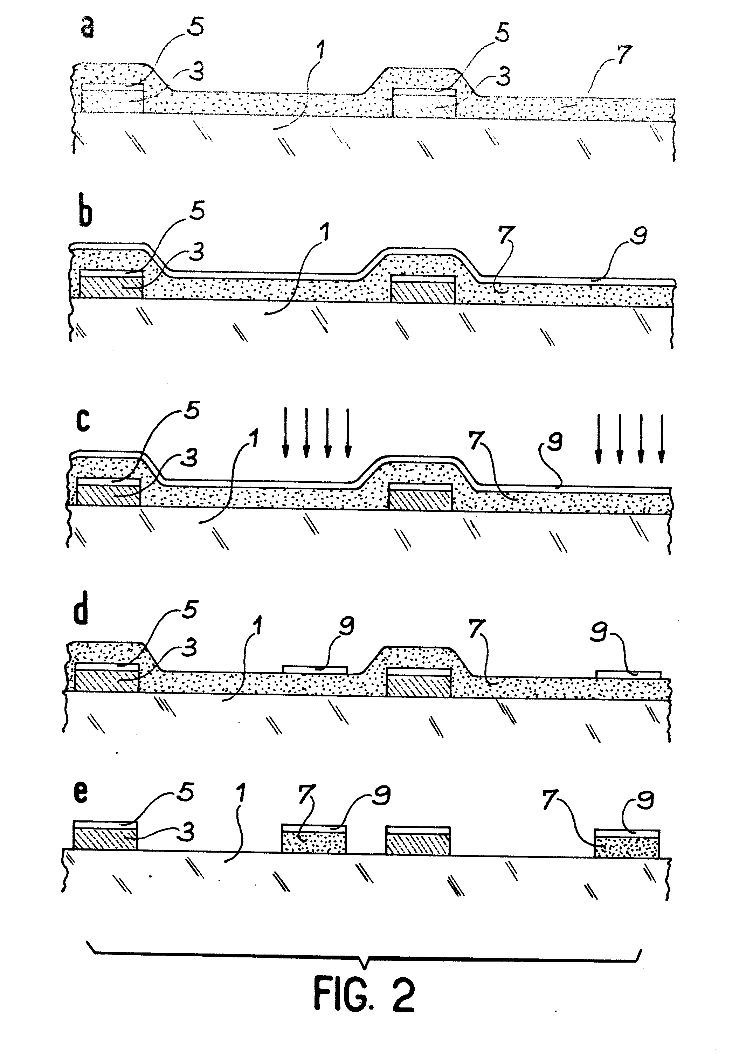

On réalise ensuite le deuxième cycle de traitement (figures 2a à 2e) pour former sur le substrat des filtres colorés en vert aux endroits voulus.

Dans ce but, on dépose tout d'abord sur l'ensemble du substrat une couche 7 de la deuxième solution colorée en vert, puis on la sèche (figure 2a). On dépose ensuite sur l'ensemble une couche de la même résine photosensible 9 que celle utilisée dans le premier cycle (figure 2b), puis on l'insole pendant 10s au travers d'un masque ayant un tracé correspondant aux emplacements des filtres verts à former, qui est décalé par rapport au masque utilisé dans le premier cycle de traitement (figure 2c). Après insolation, on élimine la résine photosensible non insolée en utilisant le même développeur et le même bain de rinçage que précédemment et en séchant ensuite l'ensemble. On obtient ainsi la structure représentée sur la figure 2d où la couche colorée en rouge 7 est revêtue en certains emplacements d'une couche de résine photosensible 9 irradiée. On élimine alors la couche colorée 7 par gravure au moyen d'un mélange éthanolméthanol aux endrois où elle n'est pas protégée par la résine 9, puis on rince à l'isopropanol, et l'on obtient ainsi la structure représentée sur la figure 2e, soit la juxtaposition de filtres (7, 9) colorés en vert et de filtres (3, 5) colorés en rouge. On rince alors comme précédemment l'ensemble à l'isopropanol, puis on le sèche pendant 1/4h à 120°C et on effectue un traitement de recuit à 160°C pendant 6 min.

Après cette opération, on effectue le troisième cycle de traitement pour former sur le substrat les filtres colorés en bleu.

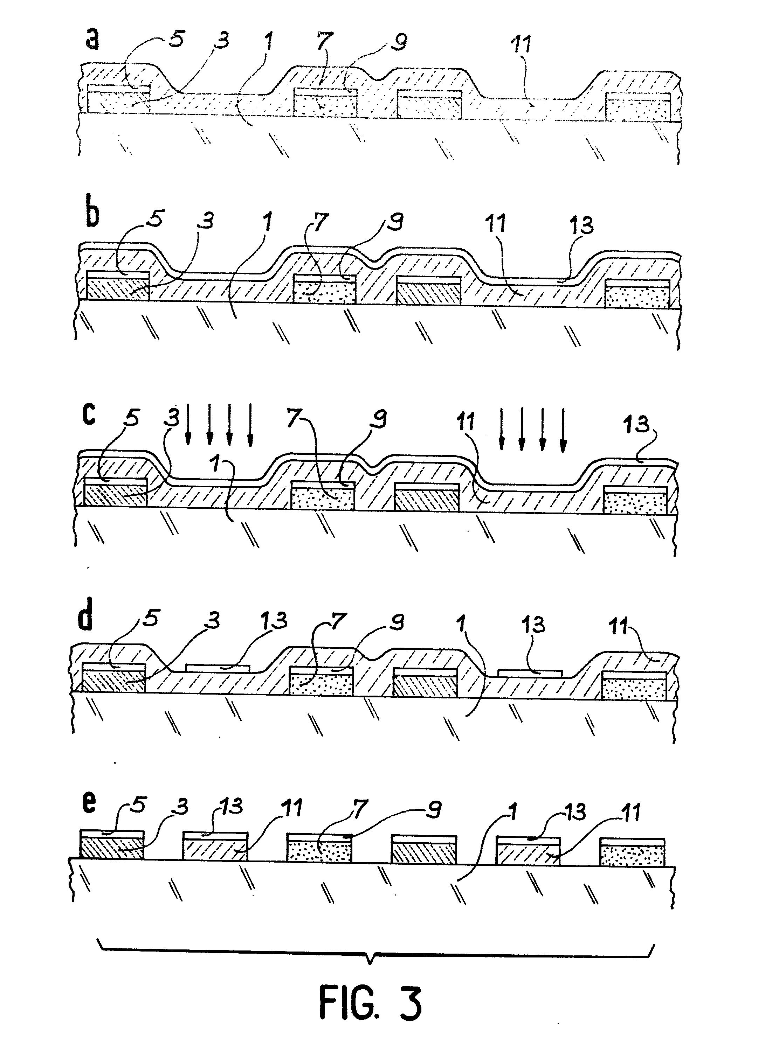

Dans ce troisième cycle, on dépose sur le substrat ayant la structure représentée sur la figure 2e, une couche 11 de la troisième solution colorée en bleu, puis on la sèche (figure 3a). On dépose ensuite sur cette couche 11, une couche 13 de la même résine photosensible (figure 3b), puis on soumet l'ensemble à une insolation en utilisant un masque définissant l'emplacement des filtres colorés en bleu qui est décalé par rapport aux masque précédemment utilisés (figure 3c).

On développe alors le dessin en utilisant le même développeur et le même bain de rinçage que précédemment et l'on obtient ainsi la structure représentée sur la figure 3d où la couche colorée en bleu 11 est revêtue en certains endroits d'une couche de résine photosensible irradiée 13 (figure 3d).

On élimine alors la couche colorée en bleu 11 aux endroits où elle n'est pas protégée par la résine 13 en utilisant le même mode opératoire que dans le premier cycle de traitement. On obtient ainsi la structure représentée sur la figure 3e où des filtres colorés en rouge (3, 5) sont juxtaposés à des filtres colorés en vert (7, 9) et à des filtres colorés en bleu (11, 13).

On réalise le traitement de recuit comme dans le premier cycle. Chaque filtre peut être protégé par la couche de résine négative (5, 9, 13) si on ne la retire pas.

On remarque ainsi que le procédé de l'invention permet de réaliser dans de bonnes conditions une mosaïque de filtres colorés pour écrans de cellules à cristaux liquides.

Exemple 2

Cet exemple illustre l'utilisation du procédé de l'invention pour former une mosaïque de filtres colorés en rouge, en vert et en bleu, en utilisant une résine positive constituée par la résine Shipley Microposit Photoresist A2 1350 S.

Dans ce cas, on réalise la premier cycle de traitement comme dans l'exemple 1, en utilisant la même solution colorée en rouge, puis on dépose la couche de résine positive et l'on réalise l'insolation pendant 20s à travers un masque ayant un tracé différent puisque dans ce cas il est nécessaire d'irradier les zones du substrat qui ne correspondent pas aux emplacements des filtres colorés. On élimine ensuite la résine irradiée en plongeant l'ensemble pendant 1 min dans un bain de développeur Shipley, puis on grave la couche colorée en rouge au moyen d'éthylène glycol et l'on réalise le recuit pendant une heure à 170°c.

Pour le second cycle de traitement, on effectue les mêmes opérations en utilisant pour le dépôt de la couche la deuxième solution colorée en vert, en réalisant ensuite l'irradiation, l'élimination de la résine et la gravure de la couche comme précédemment, mais en effectuant le recuit à une température de 120°C pendant 20 min.

Pour le dernier cycle de traitement, on procède comme pour le premier cycle de traitement, mais en utilisant la troisième solution colorée en bleu et sans effectuer l'étape de recuit.

En effet, on préfère dans ce cas éliminer la résine qui reste sur le filtre coloré en la dissolvant dans de l'isobutyméthyl cétone. Après cette opération, on soumet l'ensemble à un recuit effectué pendant deux heures à une température de 170°C.

Exemple 3

Dans cet exemple, on utilise le même mode opératoire que dans l'exemple 2, avec la même résine photosensible positive mais on effectue les premier, second et troisième cycles de traitement en gravant les couches 3, 7 et 11 par frottage au moyen d'un chiffon trempé dans une solution comportant 75% d'acide formique et 25% d'eau.

**Revendications**

1. Procédé de réalisation de filtres colorés sur un substrat comprenant une étape de définition des emplacements des filtres par un procédé lithographique utilisant une couche de résine photosensible et un premier solvant pour éliminer la résine photosensible aux endroits voulus, caractérisé en ce qu'il consiste à réaliser au moins un cycle de traitement comprenant les étapes successives suivantes :

a) dépôt sur le substrat (1) d'une première couche (3) d'une solution d'au moins un polymère insoluble dans le premier solvant et d'au moins un colorant plastosoluble,

b) dépôt d'une deuxième couche (5) de résine photosensible,

c) irradiation de certaines zones de la deuxième couche (5) de résine photosensible de façon à définir les emplacements des filtres,

d) élimination de la résine photosensible (5) par le premier solvant sur les zones du substrat ne correspondant pas auxdits emplacements,

e) élimination de la couche de polymère et de colorant (3) par un second solvant sur les zones du substrat qui ne sont plus protégées par la résine photosensible, ledit second solvant ne dissolvant pas la résine photosensible qui reste sur le substrat après l'étape d), et

f) recuit du substrat revêtu à une température et pendant une durée suffisantes pour durcir les filtres colorés.

2. Procédé de réalisation d'une mosaïque de filtres colorés selon la revendication 1, caractérisé en ce que l'on répète au moins une fois le cycle de traitement en utilisant dans l'étape a) un colorant plastosoluble différent et en définissant dans les étapes c) à e) des emplacements de filtres différents.

3. Procédé selon l'une quelconque des revendications 1 et 2, caractérisé en ce que le polymère non soluble dans le premier solvant est un polyamide.

4. Procédé selon la revendication 3, caractérisé en ce que la solution utilisée dans l'étape a) est une solution de polyamide et de colorant plastosoluble dans de l'acide formique.

5. Procédé selon l'une quelconque des revendications 1 à 4, caractérisé en ce que le second solvant est constitué par au moins un alcool ou un polyalcool.

6. Procédé selon l'une quelconque des revendications 1 à 4, caractérisée en ce que la résine photosensible est une résine négative, transparente après irradiation.

7. Procédé selon la revendication 6, caractérisé en ce que le second solvant est choisi parmi l'éthanol, le méthanol et leurs mélanges.

8. Procédé selon la revendication 5, caractérisé en ce que la résine photosensible étant une résine positive, le second solvant est l'éthylène glycol.

9. Procédé selon l'une quelconque des revendications 1 à 4, caractérisé en ce que la résine photosensible étant une résine positive, on utilise comme second solvant, une solution aqueuse d'acide formique.

10. Procédé selon l'une quelconque des revendications 1 à 4, 8 et 9, caractérisé en ce que la résine photosensible étant une résine positive, on élimine ladite résine positive à la fin du dernier cycle de traitement avant d'effectuer le traitement de recuit correspondant à ce dernier cycle de traitement.

11. Filtre coloré, caractérisé en ce qu'il est constitué par un polyamide durci contenant un colorant plastosoluble.

12. Mosaïque de filtres colorés déposés sur un substrat, caractérisée en ce que chaque filtre coloré est constitué de polyamide durci contenant un colorant plastosoluble différent de celui des filtres adjacents.

13. Solution utilisable pour la réalisation d'un filtre coloré sur un substrat, caractérisée en ce qu'elle est constituée par une solution d'au moins un polyamide et d'au moins un colorant plastosoluble dans de l'acide formique.

FIG. 1

0240378

FIG. 2

**FIG. 3**

Office européen
des brevets

**RAPPORT DE RECHERCHE EUROPEENNE**

Numéro de la demande

EP 87 40 0361

| | **DOCUMENTS CONSIDERES COMME PERTINENTS** | | |
|---|---|---|---|
| Catégorie | Citation du document avec indication, en cas de besoin, des parties pertinentes | Revendication concernée | CLASSEMENT DE LA DEMANDE (Int. Cl.4) |
| A | PATENT ABSTRACTS OF JAPAN, vol. 7, no. 202 (P-221)[1347], 07 septembre 1983; & JP-A-58 100 108 (NIPPON VICTOR K.K.) 14-06-1983 * Résumé * | 1,2,11 | G 02 F 1/133 |
| | --- | | |
| A | PATENT ABSTRACTS OF JAPAN, vol. 7, no. 238 (P-231)[1383], 22 octobre 1983; & JP-A-58 126 507 (KONISHIROKU SHASHIN KOGYO K.K.) 28-07-1983 * Résumé * | 1,2 | |
| | --- | | |
| A | PATENT ABSTRACTS OF JAPAN, vol. 7, no. 206 (P-222)[1351], 10 septembre 1983; & JP-A-58 100 803 (KONISHIROKU SHASHIN KOGYO K.K.) 15-06-1983 * Résumé * | 1,2 | **DOMAINES TECHNIQUES RECHERCHES (Int. Cl.4)** |
| | --- | | G 02 F G 02 B |
| A | PATENT ABSTRACTS OF JAPAN, vol. 6, no. 92 (P-119)[970], 29 mai 1982; & JP-A-57 27 212 (CANON K.K.) 13-02-1982 * Résumé * | 1,2 | |
| | --- -/- | | |

Le présent rapport de recherche a été établi pour toutes les revendications

| Lieu de la recherche | Date d'achèvement de la recherche | Examinateur |
|---|---|---|
| LA HAYE | 11-06-1987 | CONRAD V.HEYDENDORFF |

OEB Form 1503 03.82

## DOCUMENTS CONSIDERES COMME PERTINENTS | Page  2

| Catégorie | Citation du document avec indication, en cas de besoin, des parties pertinentes | Revendication concernée | CLASSEMENT DE LA DEMANDE (Int. Cl.4) |
|---|---|---|---|
| A | PATENT ABSTRACTS OF JAPAN, vol. 9, no. 58 (P-341)[1781], 14 mars 1985; & JP-A-59 193 423 (DAINIHON SCREEN SEIZOU K.K.) 02-11-1984 * Résumé * | 1,2 | |
| | --- | | |
| A | GB-A-2 081 462  (DAINIPPON SCREEN) *  En  entier  * & US-A-4 383 017 (HIROFUMI SHIMUZU et  al.)  (Cat. D,A) | 1,2 | |
| | ----- | | |

DOMAINES TECHNIQUES
RECHERCHES (Int. Cl.4)

Le présent rapport de recherche a été établi pour toutes les revendications

| Lieu de la recherche | Date d'achèvement de la recherche | Examinateur |
|---|---|---|
| LA HAYE | 11-06-1987 | CONRAD V.HEYDENDORFF |

OEB Form 1503 03 82